(19) Europäisches Patentamt
European Patent Office
Office européen des brevets

(11) **EP 2 830 226 A1**

(12) **EUROPEAN PATENT APPLICATION**

(43) Date of publication:
**28.01.2015 Bulletin 2015/05**

(51) Int Cl.:
**H03M 13/09** (2006.01)    **G06F 11/08** (2006.01)

(21) Application number: **13177847.4**

(22) Date of filing: **24.07.2013**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(71) Applicant: **Arrigo, Pierre**
**2034 Peseux (CH)**

(72) Inventor: **Arrigo, Pierre**
**2034 Peseux (CH)**

(74) Representative: **P&TS SA (AG, Ltd.)**
**Av. J.-J. Rousseau 4**
**P.O. Box 2848**
**2001 Neuchâtel (CH)**

(54) **Encoding and decoding methods and devices**

(57)    The present inventions concerns a method for encoding and decoding a block comprising a first value (C1), a second value (C2) and m-2 values (Vn), wherein m is an integer equal to or greater than 3, in which the first and the second value are calculated so that
- the sum in a Galois field of the first value (C1), the second value (C2) and the m-2 values (Vn) is predetermined, for example zero

- the sum in the Galois field of the weighted first value (1 *C1), the weighted second value (2*C2) and the weighted m-2 values (Pn) is predetermined, for example zero.

Each weighted value is obtained by multiplying in the Galois field first value (C1), the second value (C2) and the m-2 values (Vn) by its corresponding rank (n), the rank (n) being an integer corresponding to the position of each values in the block.

Fig. 1

EP 2 830 226 A1

**Description**

Field of the invention

The present invention concerns encoding and decoding methods and devices.

Description of related art

In communication and information processing, codes such as Hamming codes and Reed-Solomon codes are widely used to detect and/or correct error bits in digital words.

Hamming codes are simple to implement. They can correct one-bit error and optionally detect two-bit errors. They are typically used to protect individual words or blocks having a width between 4 bits and 32 bits. The software or hardware implementation of the Hamming codes is relatively easy and for such a reason they are widely used. The maximum length of the Hamming codes is theoretically unlimited. However in practice it is limited to 64 bits (i.e. 8 bytes): in fact, since Hamming codes work on single bits, their implementation for a number of bits higher than 64 is slow and cumbersome.

Reed-Solomon codes are more complex. They can correct n symbols (usually bytes) and detect errors in n (or more) symbols with a variable probability. They are used to protect data blocks with a length generally comprised between 16 bytes and 250 bytes. They are flexible and their correction power is better than the correction power of other codes, e.g. of the Hamming codes.

However the implementation of Reed-Solomon codes is more complex than the Hamming codes. Moreover the detection and the correction of errors require a long time calculation.

For some applications, the Hamming codes are too inefficient and the Reed-Solomon codes too complex and slow.

In this context an error correction system combining the advantages of Hamming codes and those of Reed-Solomon while minimizing their disadvantages would be an interesting solution.

Brief summary of the invention

According to the invention, these aims are achieved by means of a method for encoding m-l values, wherein m is an integer greater or equal than 3, wherein l is an integer greater or equal than two, comprising the following steps:

- computing in a Galois field redundancy values including a first value and a second value,
- assigning to each of said redundancy values and said m-l values a different rank, said rank being an integer belonging to the range 1 to m, the rank of said first value being 1 and the rank of said second value being 2,
- multiplying in said Galois field each of said redundancy values and said m-l values by their corresponding ranks, and obtaining corresponding weighted values,
  wherein
  said first value and said second value are computed in said Galois field so that

  - the sum in said Galois field of said redundancy values and said m-l values is predetermined, for example zero;
  - the sum in said Galois field of the weighted redundancy values and the weighted m-l values is predetermined, for example zero

Advantageously the first value and the second value are computed in the Galois field so that:

- the sum in the Galois field of the redundancy values and the m-l values is predetermined, for example zero,
- the sum in the Galois field of the weighted redundancy values and the weighted m-l values is predetermined, for example zero.

In one embodiment the multiplying in the Galois is being based on the irreducible polynomial $p(x) = x^8 + x^6 + x^3 + x^2 + 1$.

The computing in the Galois field of the second value comprises the following steps:

- summing in the Galois field the m-l values, and obtaining a first partial sum,
- summing in the Galois field the m-l weighted values, and obtaining a second partial sum,
- computing an inverse operation on the results of a XOR operation between the first partial sum and the second partial sum.

This inverse operation allows to calculate a value r from the knowledge of a value d, r and d being related by the following formula

$$d = m2(r) \; XOR \; r$$

wherein m2 ( r ) indicates 2*r.

Advantageously the first value is computed by performing a XOR operation between the first partial sum and the second value.

In one preferred embodiments the values are bytes and the considered Galois field is the GF(256) Galois field.

In one preferred embodiment I equals 2, and the redundancy values includes only saif fist value C1 and second value C2.

The invention concerns also a device for encoding m-l values, comprising:

- computing modules arranged for computing in a Galois field redundancy values including a first value and a second value selected so that

  - the sum in said Galois field of said redundancy values and said m-l values is predetermined, preferably zero
  - the sum in said Galois field of weighted redundancy values and weighted m-l values is predetermined, preferably zero
    each weighted value being the result of multiplying in said Galois field each value by a different rank, said rank being an integer belonging to the range from 1 to m, the rank of said first value being 1 and the rank of said second value being 2,

- a multiplexer for selecting said redundancy values and said m-l values so as to create a block.

The invention concerns also a method for decoding m values, wherein m is a integer equal or greater than 3, wherein I is an integer greater or equal than two, comprising the following steps:

- receiving a block of m values, comprising a first value, a second value and m-l values,
- multiplying in a Galois field each value of said block by a different rank, said rank being an integer belonging to the range from 1 to m, the rank of said first value being 1 and the rank of said second value being 2,
- summing in said Galois field said m values, and obtaining a first total sum ($\Sigma V$),
- summing in said Galois field said m weighted values, and obtaining a second total sum,
- verifying if at least one of said first total sum or said second total sum is different from a predetermined value, for example zero,
- if at least one of said first total sum or said second total sum is different from this predetermined value, determining the position of an erroneous value and correcting said erroneous value.

In one embodiment the determination of the position of the erroneous value comprises dividing in the Galois field said second total sum by the first total sum.

In an alternative embodiment the determination of the position of the erroneous value comprises verifying by using a brute force method which value of n satisfies the following formula:

$$\Sigma P = mul(n, \Sigma V).$$

The correction of the erroneous value comprises applying a XOR operation between said erroneous value and said first total sum ($\Sigma V$).

Advantageously in the decoding method according to the invention the outputting of corrected values from a decoder is carried out in parallel with their input into the decoder.

The invention concerns also a device for decoding m values, wherein m is an integer equal or greater than 3, comprising:

- an input module for receiving a block of values comprising a first value, a second value and m-l values,
- a first counter arranged for indicating the current rank of each of the m values, counting backwards from m to 1, said rank being an integer belonging to the range from 1 to m, the rank of said first value being 1 and the rank of said second value being 2,
- a multiplier arranged for multiplying in a Galois field each value of said block by its corresponding rank (n),
- a first XOR module and a second register arranged for summing in said Galois field said m values, and obtaining a first total sum,
- a second XOR module and a third register being arranged for summing in said Galois field said m weighted values, and obtaining a second total sum,
- a first comparator arranged for verifying if at least one of said first total sum or said second total sum is different from a predetermined value, for example zero,
- a computing module arranged for determining the position of an erroneous value in said block.

In a preferred embodiment device for decoding m values comprises:

- a first XOR module, a first and a second registers arranged for summing in said Galois field said m values, and obtaining a first total sum,
- a second XOR module, a third and a fourth registers being arranged for summing in said Galois field said m weighted values, and obtaining a second total sum ($\sum$P).

In a first variant the computing module comprises a divider arranged for dividing the second total sum by the first total sum so as to determine the rank of an erroneous value in the ordered block, if at least one of the first total sum or the second total sum is different from a predetermined value, for example zero.
In a second variant the computing module comprises a multiplier arranged for multiplies the first total sum by the current rank n from a second counter by applying a force brute method, so as to determine the rank of an erroneous value in the ordered block, if at least one of the first total sum or the second total sum is different from a predetermined value, for example zero.
A third XOR module is then arranged for correcting the erroneous value from the value having the rank of the erroneous value, and the first total sum.
The present invention further concerns a computer-program product for causing an apparatus to encode m-l values respectively to decode m values, comprising a tangible computer usable medium including computer usable program code being used for performing the steps of the encoding respectively decoding method according to the invention.
The present invention further concerns a computer data carrier storing data encoded with the encoding method according to the invention.
The inventive encoding and decoding method according to the invention have the following benefits:

- reduced complexity of the encoding and decoding methods,
- complexity relatively balanced between the encoding and decoding methods,
- simplified implementation,
- the decoding method is rapid and does not have iterative process,
- the methods for encoding and decoding are independent from the length of the block.

The encoding device preferably works in a continuous flow, one byte per clock cycle. The decoding devices works as well in a continuous flow, one byte per clock cycle. There is a constant flow of encoded resp. decoded data, even when an error needs to be corrected (time zero correction).
This constant flow in the decoding device is due to the presence of four registers, two for the partial sums and two for the total sums. The two registers of the partial sums are continuously updated and, once the total sums are computed, the two registers of the total sums are fixed.
Moreover the hardware implementation of the encoding and decoding devices is simple compared to the Reed-Solomon encoding and decoding device and allows a higher frequency than encoding and decoding devices based on Reed-Solomon.
It is possible to dynamically reconfigure the encoder and decoder if the blocks have variable length (time zero reconfiguration).
It is possible to parallelize the encoding and decoding methods, with a throughput of n bytes per clock cycle.

Brief Description of the Drawings

The invention will be better understood with the aid of the description of an embodiment given by way of example and illustrated by the figures, in which:

Fig. 1 shows a view of an embodiment of the encoding device according to the invention.

Fig. 2 shows a view of a first embodiment of the decoding device according to the invention.

Fig. 3 shows a view of a second embodiment of the decoding device according to the invention.

Detailed Description of possible embodiments of the Invention

The encoding and decoding methods and devices according to the present invention are based on blocks (or word or list) comprising m values (or numbers), wherein m is an integer equal or greater than 3. In particular, the methods and devices are based on "perfect block", i.e. blocks having some specific features

Starting from a list of m original values Vn, it is possible to define a list of weighted values Pn, in which each weighted value Pn is obtained by multiplying each original value by a weight, this weight being an integer corresponding to the position (or rank) of this number in the list of original values Vn.

The weights or ranks n are not necessarily in a decreasing order.

| Original values $(V_n)$ | Weight $(n)$ | Weight values $(P_n)$ |
|---|---|---|
| $V_m$ | $m$ | $m * V_m$ |
| $V_{m-1}$ | $m$-1 | $(m$-1$) *V_{m-1}$ |
| $V_{m-2}$ | $m$-2 | $(m$-2$) * V_{m-2}$ |
| ... | ... | ... |
| ... | ... | ... |
| $V_3$ | 3 | $3 * V_3$ |
| $V_2$ | 2 | $2 * V_2$ |
| Original values $(V_n)$ | Weight $(n)$ | Weighted values $(P_n)$ |
| $V_1$ | 1 | $1 * V_1$ |

In this context a block is a "perfect block" if the two following conditions are simultaneously met:

- the sum of all the original values Vn is predetermined, for example zero, i.e. $\sum V = 0$; and
- the sum of all the weighted values Pn is predetermined, for example zero, i.e. $\sum P = 0$.

The table here below illustrates an example of a perfect block:

| Original values $(V_n)$ | Rank=Weight $(n)$ | Weighted values $(P_n)$ |
|---|---|---|
| -8 | 6 | -48 |
| 2 | 5 | 10 |
| -5 | 4 | -20 |
| 14 | 3 | 42 |
| 19 | 2 | 38 |
| -22 | 1 | -22 |
| | | |
| $\sum V = 0$ | | $\sum P = 0$ |

An interesting property of perfect blocks is their ability to self-repair. In fact, by using a simple method, it is possible to repair any value of the block that was previously damaged.

The following table illustrates an example where the fifth element of the block (from the bottom) of the table above is changed by replacing the value 2 with the value 10, which gives the following result:

| Original values $(V_n)$ | Weight $(n)$ | Weighted values $(P_n)$ |
|---|---|---|
| −8 | 6 | −48 |
| 10 | ⑤ | 50 |
| −5 | 4 | −20 |
| 14 | 3 | 42 |
| 19 | 2 | 38 |
| −22 | 1 | −22 |

| $\Sigma V = 8$ | $\Sigma P = 40$ |
|---|---|

A corrupted block, i.e. a block containing at least one erroneous value, is identifiable if the sum of all the original values or the sum of all the weighted values is different from a predetermined value, for example zero.

The correction of an erroneous value is performed by using the following two formulas:

$$\bullet \ \text{Erroneous value position} = \Sigma P / \Sigma V$$

In the example above, erroneous value position = 40/8 = 5

$$\bullet \ \text{Corrected value} = \text{Erroneous value} - \Sigma V$$

In the example above, corrected value = 10 - 8 = 2

| Original values $(V_n)$ | Weight $(n)$ | Weighted values $(P_n)$ |
|---|---|---|
| -8 | 6 | -48 |
| 10 → 2 | ⑤ | 50 → 10 |
| -5 | 4 | -20 |
| 14 | 3 | 42 |
| 19 | 2 | 38 |
| -22 | 1 | -22 |
| | | |

(continued)

| Original values $(V_n)$ | Weight $(n)$ | Weighted values $(P_n)$ |
|---|---|---|
| $\Sigma V = 8 \rightarrow 0$ | | $\Sigma P = 40 \rightarrow 0$ |

This self-repair property is based on hidden redundancies of the perfect block, and related to the fact that the sum of all the original values Vn and of all the weighted values Pn must be a predetermined value, for example zero.

For storing arbitrary data in a perfect block, it is possible to add I redundancy values to an existing list of m-I values that one wants to encode, wherein the redundancy values are selected so that the block of m-I values and I redundancy values is a perfect block. m is an integer greater or equal than 3.

It could be shown that for any number m-I of values to encode, it is possible to form a perfect block by adding only I=2 redundancy values. However, a higher number I of redundancy values could be added, possibly to improve the error detection or error correction capability.

Thus, the only way to have the two sums equal to a predetermined value, for example zero, in all circumstances is to compute and insert I redundancy values, for example two redundancy values C1, C2 at the end of the block, as follows:

| Original values $(V_n)$ | Weight $(n)$ | Weighted values $(P_n)$ |
|---|---|---|
| $V_m$ | $m$ | $m * V_m$ |
| $V_{m-1}$ | $m-1$ | $(m-1) * V_{m-1}$ |
| $V_{m-2}$ | $m-2$ | $(m-2) * V_{m-2}$ |
| ... | ... | ... |
| ... | ... | ... |
| $V_3$ | $3$ | $3 * V_3$ |
| $C_2$ | ② | $2 * C_2$ |
| $C_1$ | ① | $1 * C_1$ |

| | |
|---|---|
| $\Sigma V = 0$ | $\Sigma P = 0$ |

The table below is an example of a partial block with four arbitrary values Vn:

| Original values ( $V_n$ ) | Weight ( $n$ ) | Weighted values ( $P_n$ ) |
|---|---|---|
| 45 | ⑥ | 270 |

| Original values ( $V_n$ ) | Weight ( $n$ ) | Weighted values ( $P_n$ ) |
|---|---|---|
| −16 | ⑤ | −80 |
| 84 | ④ | 336 |
| −32 | ③ | −96 |
| ? | 2 | ? |
| ? | 1 | ? |

| ΣVpart = 81 | ΣPpart = 430 |
|---|---|

The following formula are then applied:

$$\bullet \ \text{Value } ② = C2 = \Sigma Vpart - \Sigma Ppart$$

In the example above, C2 = 81 - 430 = -349
• Value ① = C1 = -ΣVpart - Value ②
In the example above C1 = -81 + 349 = 268

| Original values ($V_n$) | Weight ($n$) | Weighted values ($P_n$) |
|---|---|---|
| 45 | 6 | 270 |
| −16 | 5 | −80 |
| 84 | 4 | 336 |
| −32 | 3 | −96 |

| Original values ($V_n$) | Weight ($n$) | Weighted values ($P_n$) |
|---|---|---|
| −349 | ② | −698 |
| 268 | ① | 268 |

| | | |
|---|---|---|
| $\Sigma V = 0$ | | $\Sigma P = 0$ |

The method of encoding described here above is adapted to signed integers in an unlimited range ($-\infty$ to $+\infty$). Unfortunately, it is difficult to apply this method to integers in a finite range, e.g. binary numbers 8-bit coded, and belonging in the range from -128 to 127 (or in a positive range 0 to 255).

For example the values (45, -16, 84 and -32) of the previous example are signed integers that can be represented by a byte. However the calculated values (-349 and 268) cannot be represented by a single byte.

This problem is mainly due to weighted values becoming progressively larger as the rank increases. In addition, intermediate sums of original and weighted values cannot be always represented by one single byte.

In order to solve this problem, it is possible to use Galois fields (or finite fields), in which the four basic operations (addition, subtraction, multiplication and division) are performed within a finite field.

As the byte is the basic unit of most computer systems, in a preferred embodiment the inventive method is performed in the Galois field GF(256) or GF($2^8$).

The addition in a Galois field is performed by a "XOR" (exclusive or) bit by bit of the two operands. This implies that the subtraction is identical to addition. However in a Galois field

$$a + a = 0 \qquad \text{and} \qquad a + a \neq 2*a$$

The multiplication depends on an irreducible polynomial which has been selected. For the GF(256) field there are 16 possibilities (decimal):

*285, 299, 301, 333, 351, 355, 357, 361, 369, 391, 397, 425,* 451, 463, 487, 501

The value 333 (or "101 001 101" in binary) which is the irreducible polynomial:

$$p(x) = x^8 + x^6 + x^3 + x^2 + 1$$

will be used in the following examples.

The multiplication by 2 is the basic operation. It is achieved by multiplying the operand by 2 modulo p(x). In this way the result remains within the Galois field.

The operand is shifted one bit to the left, and if the result is higher than 255, p(x) is subtracted. Let $\{r7 \ldots r0\}$ being the result and $\{d7 \ldots d0\}$ the operand, then

$$\{r7, r6, r5, r4, r3, r2, r1, r0\} = \{(d7,) d6, d5, d4, d3, d2, d1, d0, 0\}$$

$$xor \{(d7,) 0, d7, 0, 0, d7, d7, 0, d7\}$$

p(x) is subtracted only if d7 = 1 (i.e. when the result is higher than 255) and the most significant bit does not need to be calculated.

In the following, the notation "m2 (d)" will designate a multiplication by 2, and more generally "mK (d)" a multiplication by K.

It is possible to perform multiplication by any power of 2 as follows:

$$m1(d) = d$$

$$m2(d) = \{d_6, d_5, d_4, d_3, d_2, d_1, d_0, 0\} \; xor \; \{0, d_7, 0, 0, d_7, d_7, 0, d_7\}$$

$$m4(d) = m2(m2(d))$$

$$m8(d) = m2(m4(d))$$

$$m16(d) = m2(m8(d))$$

$$m32(d) = m2(m16(d))$$

$$m64(d) = m2(m32(d))$$

$$m128(d) = m2(m64(d))$$

The multiplication of two bytes is defined by the following formulae:

$$mul(c, d) = (8\{c_7\} \ and \ m128(d))$$
$$xor(8\{c_6\} \ and \ m64(d))$$
$$xor(8\{c_5\} \ and \ m32(d))$$
$$xor(8\{c_4\} \ and \ m16(d))$$
$$xor(8\{c_3\} \ and \ m8(d))$$
$$xor(8\{c_2\} \ and \ m4(d))$$
$$xor(8\{c_1\} \ and \ m2(d))$$
$$xor(8\{c_0\} \ and \ m1(d))$$

The notation "x {cn}" indicates a replication:

$$8\{c_n\} = \{c_n, c_n, c_n, c_n, c_n, c_n, c_n, c_n\}$$

The simplest method for performing a division is to multiply the operand by the inverse of the other, e.g. by using a table of inverses. This table contains 256 elements (eo to $e_{255}$) and is constructed using the method of brute force, i.e. the method in which all theoretically possible solutions of a problem are verified until finding the correct one.
For example for each value of n in the range 1 to 255, a value en is calculated so that the following relation is true:

$$mul(n, e_n) = 1$$

The inverse value is defined as

$$inverse(d) = e_d$$

The division of two bytes is then defined by the following formula:

$$div(c, d) = mul(c, inverse(d))$$

As will be discussed, it is interesting to know also how to calculate *r=inv_op (d)* starting from

$$d = 2*r - r$$

Since the particular property of a Galois field according which (r + ≠ # 2 * r), it is not possible to simplify the equation here above. In a Galois field then r will be calculated starting from

$$d = m2(r) \ xor \ r$$

i.e.

$$\{d_7, d_6, d_5, d_4, d_3, d_2, d_1, d_0\} = \{r_6, r_5, r_4, r_3, r_2, r_1, r_0, 0\}$$
$$xor \ \{0, r_7, 0, 0, r_7, r_7, 0, r_7\}$$
$$xor \ \{r_7, r_6, r_5, r_4, r_3, r_2, r_1, r_0\}$$

r is then calculated as it follows:

$$r_7 = d_7 \; xor \; d_6 \; xor \; d_5 \; xor \; d_4 \; xor \; d_3 \; xor \; d_2 \; xor \; d_1 \; xor \; d_0$$

$$r_6 = d_6 \; xor \; d_5 \; xor \; d_4 \; xor \; d_3 \; xor \; d_2 \; xor \; d_1 \; xor \; d_0$$

$$r_5 = d_7 \; xor \; d_6$$

$$r_4 = d_7 \; xor \; d_6 \; xor \; d_5$$

$$r_3 = d_7 \; xor \; d_6 \; xor \; d_5 \; xor \; d_4$$

$$r_2 = d_2 \; xor \; d_1 \; xor \; d_0$$

$$r_1 = d_7 \; xor \; d_6 \; xor \; d_5 \; xor \; d_4 \; xor \; d_3 \; xor \; d_2$$

$$r_0 = d_7 \; xor \; d_6 \; xor \; d_5 \; xor \; d_4 \; xor \; d_3 \; xor \; d_2 \; xor \; d_1$$

It is possible now to build a perfect block by using operations in the Galois field GF(256), by calculating the values C1 and C2 from arbitrary values V3 to Vm so that each amount (original and weighted) is equal to a predetermined value, for example zero.

| Original values $(V_n)$ | Weight $(n)$ | Weighted values $(P_n)$ |
|---|---|---|
| $V_m$ | $m$ | $m * Vm$ |
| $V_{m-1}$ | $m$-1 | $(m$-1$) * V_{m-1}$ |
| ... | ... | ... |
| ... | ... | ... |
| $V_4$ | 4 | $4 * V_4$ |
| $V_3$ | 3 | $3 * V_3$ |
| $\sum V_{part} = 0$ | | $\sum P_{part} = 0$ |
| | | |
| $C_2$ | 2 | $2 * C_2$ |
| $C_1$ | 1 | $1 * C_1$ |
| $\sum V = 0$ | | $\sum P = 0$ |

The first step is to calculate for n ranging from 3 to m, the weighted values by using the function mul (c, d):

$$P_n = mul \, ( \, n, \, V_n \, )$$

The second step is to calculate the partial sums of the original and weighted values for n ranging from 3 to m, as follows:

$$\Sigma Vpart = V3 \ xor \ V4 \ xor \ ... \ xor \ Vm-1 \ xor \ Vm$$

$$\Sigma Ppart = P3 \ xor \ P4 \ xor \ ... \ xor \ Pm-1 \ xor \ Pm$$

In order to calculate C2, it is possible to write:

$$\Sigma Vpart + C_2 = \Sigma Ppart + 2*C_2$$

$$\Sigma Vpart - \Sigma Ppart = 2*C_2 - C_2$$

By using inv_op (d) it is then possible to calculate C2 as follows:

$$C2 = inv\_op(\Sigma Vpart \ xor \ \Sigma Ppart)$$

It is finally possible to calculate C1 as indicated here below :

$$C_1 = \Sigma Vpart \ xor \ C_2$$

The fact that C1 and C2 are placed at the locations wherein the weights are respectively equal to 1 and 2 is essential. In fact the calculation of C2 is related to the balance of the two partial sums ($\Sigma Vpart$ and $\Sigma Ppart$). Equilibrium between the two sums is achieved when:

$$\Sigma Vpart + C_2 = \Sigma Ppart + 2*C_2$$

Since in a Galois field $\Sigma Vpart - \Sigma Ppart \neq C2$, C2 is calculated by using the inverse operation inv_op (d).

$$C_2 = inv\_op(\Sigma Vpart \ xor \ \Sigma Ppart)$$

C1 is then determined as indicated here below:

$$C1 = \Sigma Vpart \ xor \ C2.$$

Balancing the two partial sums $\Sigma Vpart$ and $\Sigma Ppart$ is only made possible by the fact that the position or rank of C2 in the perfect block is equal to 2, i.e. that the weight by which C2 is multiplied is 2.

The calculation of C1 is intended to supplement the two partial sums (now equal) so that the total sums $\Sigma V$ and $\Sigma P$ are both equal to a predetermined value, for example zero. The fact that the total sums $\Sigma V$ and $\Sigma P$ are both equal to a predetermined value, for example zero, is only made possible by the fact that the position or rank of C1 in the perfect block is equal to 1, i.e. that the weight by which C1 is multiplied is 1.

The table here below is an example of building a perfect block. It includes the original values of the previous example, but uses the decimal representation unsigned. All operations are performed in the Galois field GF(256).

| 45 | 6 | 238 |
|---|---|---|
| 240 | 5 | 231 |
| 84 | 4 | 29 |
| 224 | 3 | 109 |
| $\Sigma Vpart = 105$ | | $\Sigma Ppart = 121$ |

(continued)

| | | |
|---|---|---|
| 203 | 2 | 219 |
| 162 | 1 | 162 |
| | | |
| $\Sigma V = 0$ | | $\Sigma P = 0$ |

The first step of repairing a perfect block in a Galois field is to calculate for n ranging from 1 to m, the weighted values Pn, by using the function mul (c, d):

$$Pn = mul\,(\,n,\,Vn\,)$$

The second step is to calculate the two total sums $\Sigma V$ and $\Sigma P$ for n ranging from 1 to m:

$$\Sigma V = V1 \; xor \; V2 \; xor \; ... \; xor \; Vm{-}1 \; xor \; Vm$$

$$\Sigma P = P1 \; xor \; P2 \; xor \; ... \; xor \; Pm{-}1 \; xor \; Pm$$

The third step is to check the integrity of a block. A block is damaged if the following relation is true:

$$(\Sigma V \neq 0\,) \quad or \quad (\Sigma P \neq 0\,)$$

In the case where the block is damaged, it is possible to find the error position n:

$$n = \Sigma P \,/\, \Sigma V$$

The rank or position n can be calculated in two different ways. A first variant A uses the function div (c, d). Then:

$$n = div\,(\Sigma P,\, \Sigma V)$$

The second variant B uses a brute force method, i.e. it checks, for n ranging from 1 to m, if the following relation is true, and when the relationship is true, n gives the position of the error.

$$\Sigma P = mul\,(\,n,\, \Sigma V\,)$$

The first variant A allows to know immediately the position of the error. However, it has the disadvantage of being quite slow since it requires to access to the inverse table and then performs the multiplication.
The second variant B may seem at first ineffective since the first multiplication is repeated a number m of times. In reality this is not a problem since these multiplications can be performed in parallel with the output of the data. In other words, since it is simple to know with the inventive method where the current value is damaged or erroneous, it is possible to correct or repair it at the precise moment when it is outputted by the decoding device.
The next step is to verify if it is possible to correct the error. A block can be corrected if the following relation is true:

$$1 \leq n \leq m$$

If the relation here above is not true, there are multiple errors.

The last step is to repair the damaged or erroneous value as follows:

$$V_n = V_n \; xor \; \Sigma V$$

The described decoding method is designed to locate and correct a single error. This method find in all cases a correction solution. But if there are several errors, and according to the theory, the method could correct a false value to a false place to put the total sums equal to a predetermined value, for example zero. This feature, a priori negative, can become interesting when using the so called shortened codes, i.e. codes in which m is comprised between 3 and 254.

In such a case, it is possible to detect multiple errors. The multiple error is detected when the calculated position falls outside the used portion of the Galois field.

The proportion of double errors that may be detected depends on the code length. If the code is shorter, the chances of detecting double errors increase, as indicated here below:

$$double\_error\_ratio \approx 1 - ( 2 + m ) / 257$$

Multiple errors can be detected also by applying two or more time the described method on the same block.

The table here below is an example of repairing or correcting a perfect block. Position 4 was damaged with the V4 value = 99. This means that the two total sums (55 and 220) are different from a predetermined value, for example zero.

The first variant A is used to find the error position:

$$div \; (220, 55) = 4$$

The corrected value Vn is calculated as follows:

$$99 \; xor \; 55 = 84$$

All these operations are performed in the Galois field GF(256).

| | | |
|---|---|---|
| 45 | 6 | 238 |
| 240 | 5 | 231 |
| $99 \rightarrow 84$ | 4 | $193 \rightarrow 29$ |
| 224 | 3 | 109 |
| 203 | 2 | 219 |
| 162 | 1 | 162 |
| | | |
| $\Sigma V = 55 \rightarrow 0$ | | $\Sigma P = 220 \rightarrow 0$ |

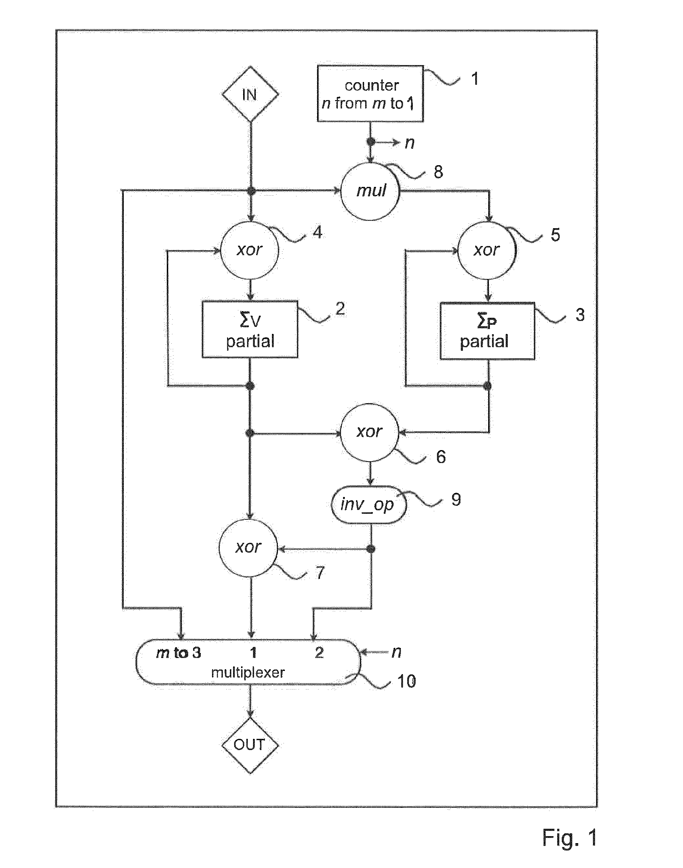

Fig. 1 shows a view of an embodiment of the encoding device according to the invention. This encoder comprises components operating in the Galois field GF(256). The encoder works with blocks composed of m bytes (m being between 3 and 255). The rank of the current byte is n.

The encoder comprises the following components:

-  A counter 1 counting backwards the rank n, from m to 1.

-  A first register 2 containing the partial sum $\Sigma Vpart$.

-  A second register 3 containing the weighted partial sum $\Sigma Ppart$.

-  A first XOR module 4, a second XOR module 5, a third XOR module 6 and a fourth XOR module 7.

- A multiplier 8.

- An inverse operator module 9.

- A 3:1 multiplexer 10.

In the embodiment of Fig.1, the encoding method comprises the following steps:

a) Registers 2 and 3 are set to zero.

b) The data to be encoded arrives to the point <IN>. The number of entering bytes is m-2. Counter 1 indicates the position or rank of each incoming and outgoing byte, counting backwards from m to 3.

c) Each entering byte goes simultaneously to three destinations:

- To the <OUT> output passing through the multiplexer 10.

- To the first register 2 passing through the first XOR module 4.

- To the second register 3 by passing through the multiplier 8 and the second XOR module 5.

d) After the entry of the bytes or values having a position from m to 3, registers 2 and 3 contain then the partial sums $\sum Vpart$ and $\sum Ppart$. From that time, registers 2 and 3 do not change.

e) Then, the counter 1 is decremented by 1 to indicate the position 2. The corresponding byte or value C2 is calculated by the third XOR module 6 and by the inverse operator module 9, and then sent to the output <OUT> through the multiplexer 10.

f) Finally, the counter 1 is decremented by 1 to indicate the position 1. The corresponding byte or value C1 is calculated by the third XOR module 6, the inverse operator module 9 and by the fourth XOR module 7, and then sent to the output <OUT> through the multiplexer 10.

g) The multiplexer 10 selects one of the three inputs "m to 3", 2, and 1 based on the position or rank n given by the counter 1.

h) The process is completed and the encoder is ready to process the next block.

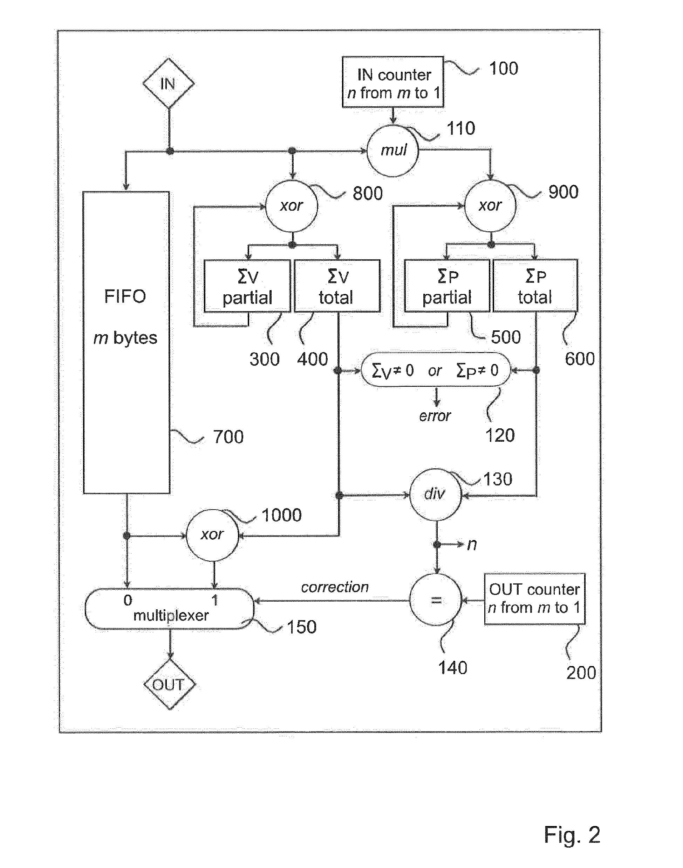

Fig. 2 shows a view of a first embodiment of the decoding device according to the invention, comprising:

- A first counter IN 100 that counts the incoming bytes from m to 1.

- A second counter OUT 200 that counts the outgoing bytes, from m to 1.

- A first register 400 that contains the total sum $\sum V$.

- A second register 300 that contains the partial sum $\sum Vpart$.

- A third register 600 that contains the total weighted sum $\sum P$.

- A fourth register 500 that contains the weighted partial sum $\sum Ppart$.

- A FIFO 700 comprising m bytes.

- A first XOR module 800, a second XOR module 900 and a third XOR module 1000.

- An input multiplier 110.

- A dual comparator 120.

- An output divider 130.

- A single comparator 140.

- An output 2:1 multiplexer 150.

In the described embodiment, the decoding method comprises the following steps:

a) Initially, registers 300 and 500 are set to zero.

b) The bytes to decode reach the point <IN>. The number of entering bytes is m. The counter 100 indicates the rank or position of each incoming byte, counting backwards from m to 1.

c) The incoming bytes having a rank between 2 and m go simultaneously to three destinations:

- Directly to the FIFO 700.

- To the second register 300 passing through the first XOR module 800.

- To the fouth register 500 passing through the multiplier 110 and the second XOR module 900.

d) The incoming byte having the rank 1 simultaneously goes to three destinations:

- Directly to the FIFO 700.

- To the first register 400 passing through the first XOR module 800.

- To the third register 600 passing through the multiplier 110 and the second XOR module 900.

e) After the treatment of bytes having a rank comprised between 1 and m, the input process of the current block is completed. The decoder is then ready to process the input of the next block.

f) The process for outputting bytes is carried out in parallel with their input into the decoder. From that moment, the content of the registers 400 and 600 does not change and include the total sums $\Sigma V$ and $\Sigma P$.

g) The first comparator 120 provides an error indication ("error" in the Fig. 2) if at least one of the two total sums $\Sigma V$ and $\Sigma P$ is different from a predetermined value, for example zero.

h) Then the divider 130 divides the total sum $\Sigma P$ contained in the register 600 by the total sum $\Sigma V$ contained in the register 400. The result gives the rank n of the error.

i) The third XOR module 1000 calculates the corrected value from the original value (having the rank n calculated in the previous step) and the total sum $\Sigma V$ contained in the register 400.

j) The counter 200 indicates the current rank of each of the m outgoing bytes, counting backwards from m to 1.

k) The comparator 140 compares the rank n of the error with the current rank of the OUT counter 200. If the two ranks are equal, it means that the outgoing byte must be corrected.

l) The multiplexer 150 selects one of its two inputs (original value or corrected value) depending on the indication and correction made by the comparator 140. The result is then sent to the output <OUT>.

m) After treating the bytes of rank from m to 1, the output process of the current block is completed. The encoder is ready to process the output of the next block.

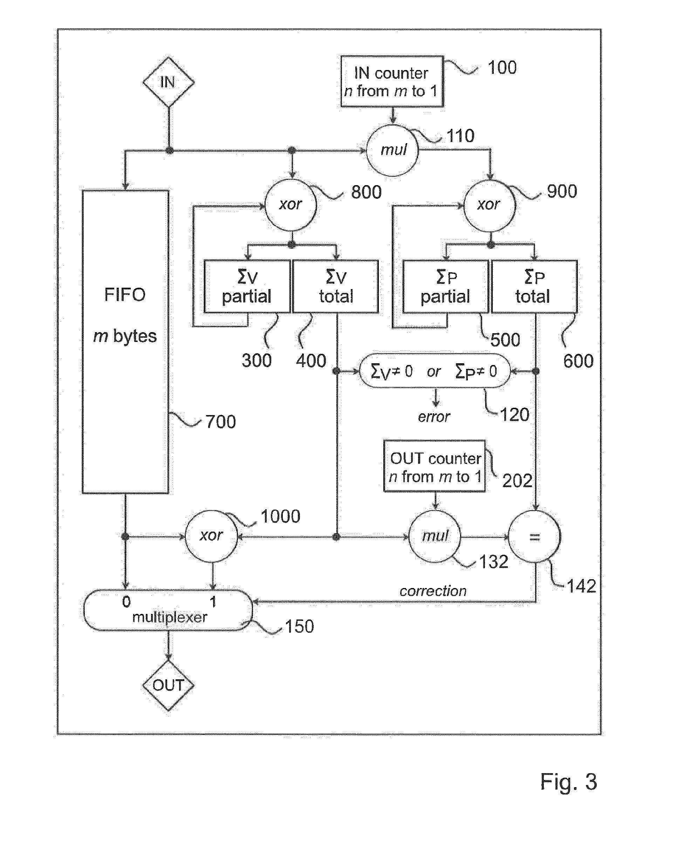

Fig. 3 shows a view of a second embodiment of the decoding device according to the invention. It differs from the decoding device of Fig. 2 since instead of the dividing module 130 there is a multiplying module 132, directly cooperating with an OUT counter 202 and a comparator 142.

In this embodiment, the decoding method comprises the steps a) to g) discussed here above, and the following steps:

h) The counter 202 indicates the current rank of each of the m outgoing bytes, counting backwards from m to 1.

i) The multiplier 132 multiplies the total sum $\sum V$ of the register 400 by the current rank n from the counter 202.

j) The comparator 142 compares the result of the multiplier 132 with the total weighted sum $\sum P$ of the register 600. If the total weighted sum $\sum P$ is equal to the total sum $\sum V$, it means that the outgoing byte must be corrected.

k) The third XOR module 1000 calculates the corrected value from the original value and the total sum $\sum V$ contained in the register 400.

l) The multiplexer 150 selects one of its two inputs (original value or corrected value) depending on the indication and correction made by the comparator 142. The result is then sent to the output <OUT>.

m) After treating the bytes of rank from m to 1, the output process of the current block is completed. The encoder is ready to process the output of the next block.

The following table illustrates a comparison between the inventive code, the Hamming code and the Reed-Solomon code:

| Features | Hamming | Invention | Reed-Solomon |
|---|---|---|---|
| Total length of a block [bytes] | typ. $\leq 8$ | $\leq 255$ | $\leq 255$ |
| Useful length of a block [bytes] | typ. $\leq 7$ | $\leq 253$ | $\leq 253$ |
| Correction capacity per block [bits] | 1 | 8 | $\geq 8$ |
| Detection capacity correction per block [bits] | 2 | $\geq 8$ | $>\geq 8$ |

Total length of a block

The maximum length of Hamming codes is theoretically unlimited. In practice, then generally do not use codes having a length greater than 64 bits. As the system works at the bit level, the implementation often becomes too slow for a length greater than 64 bits.
The maximum length of the inventive code is limited by the size of the corresponding Galois field. With 8-bit symbols working in GF($2^8$), the maximum length is $2^8 - 1 = 255$ bytes.
The Reed-Solomon codes also work in GF($2^8$). The maximum length is equal to 255.

Capacity correction and detection

Hamming codes can correct 1-bit errors and detect 2-bit errors.
The inventive code can correct 1 byte (8 bits) and detect with a variable probability errors of more than one byte.
The Reed-Solomon codes can correct n bytes, and detect with a variable probability errors greater than n bytes. The most common values of n are: 1, 2, 4, 8 and 16.

Overhead

The overhead is the ratio between the length of the code redundancy and the effective length data. Compactness of the code system depends on the overhead.
The following table shows a comparison between the overheads of the inventive codes, the Hamming code and the Reed-Solomon code:

| Overhead | Hamming [bits] | Invention [bytes] | Reed–Solomon [bytes] |
|---|---|---|---|
| Useful length: 4 bytes | (39,32) | (6,4) | RS (6,4) |
| Global overhead | 21.9 % | 50 % | 50 % |
| Overhead per corrected bit | 21.9 % | 6.25 % | 6.25 % |
| Useful length: 16 bytes | 3 blocks (50,43) | (18,16) | RS (18,16) |

| | Hamming [bits] | Invention [bytes] | Reed–Solomon [bytes] |
|---|---|---|---|
| Global overhead | 16.3 % | 12.5 % | 12.5 % |
| Overhead per corrected bit | 5.4 % | 1.6 % | 1.6 % |
| Useful length: 64 bytes | 9 blocks (64,57) | (66,64) | RS (66,64) |
| Global overhead | 12.3 % | 3.1 % | 3.1 % |
| Overhead per corrected bit | 1.4 % | 0.39 % | 0.39 % |
| Useful length: 250 bytes | 36 blocks (63,56) | (252,250) | RS (252,250) |
| Global overhead | 12.5 % | 0.8 % | 0.8 % |
| Overhead per corrected bit | 0.35 % | 0.1 % | 0.1 % |

The Hamming codes have an overall overhead higher than the other two solutions, except in the case of small blocks. On the other hands, the overhead compared to the number of bits that can be corrected is higher than the other solutions.

The inventive code and the Reed-Solomon code have the same fixed overhead per bit, regardless of the configuration of the Reed-Solomon codes (correction of any number of bytes).

The inventive code lies between the Hamming codes and Reed-Solomon. It has the simplicity and an easy implementation as the Hamming codes. It has the flexibility and power of correction of Reed-Solomon codes. In other words, it combines the advantages of Hamming codes and those of Reed-Solomon while minimizing their drawbacks.

In one or more examples, the functions described may be implemented in hardware, software, firmware, or any combination thereof. If implemented in software, the functions may be stored on or transmitted over as one or more instructions or code on a computer-readable medium. Computer-readable media may includes computer data storage media or communication media including any medium that facilitates transfer of a computer program from one place to another. Data storage media may be any available media that can be accessed by one or more computers or one or more processors to retrieve instructions, code and/or data structures for implementation of the techniques described in this disclosure. By way of example, and not limitation, such computer-readable media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Also, any connection is properly termed a computer-readable medium. For example, if the software is transmitted from a website, server, or other remote source using a coaxial cable, fiber optic cable, twisted pair, digital subscriber line (DSL), or wireless technologies such as infrared, radio, and microwave, then the coaxial cable, fiber optic cable, twisted pair, DSL, or wireless technologies such as infrared, radio, and microwave are included in the definition of medium. Disk and disc, as used herein, includes compact disc (CD), laser disc, optical disc, digital versatile disc (DVD), floppy disk and Blu-ray disc where disks usually reproduce data magnetically, while discs reproduce data optically with lasers. Combinations of the above should also be included within the scope of computer-readable media.

The code may be executed by one or more processors, such as one or more digital signal processors (DSPs), general purpose microprocessors, application specific integrated circuits (ASICs), field programmable logic arrays (FPGAs), or other equivalent integrated or discrete logic circuitry. Accordingly, the term "processor," as used herein may refer to any of the foregoing structure or any other structure suitable for implementation of the techniques described herein. In addition, in some aspects, the functionality described herein may be provided within dedicated hardware and/or software modules configured for encoding and decoding, or incorporated in a combined codec. Also, the techniques could be fully implemented in one or more circuits or logic elements.

The techniques of this disclosure may be implemented in a wide variety of devices or apparatuses, including a wireless handset, an integrated circuit (IC) or a set of ICs (i.e., a chip set). Various components, modules or units are described in this disclosure to emphasize functional aspects of devices configured to perform the disclosed techniques, but do not necessarily require realization by different hardware units. Rather, as described above, various units may be combined in a codec hardware unit or provided by a collection of interoperative hardware units, including one or more processors as described above, in conjunction with suitable software and/or firmware.

**Claims**

1. A method for encoding m-l values (Vn), wherein m is an integer greater or equal than 3 and wherein l is an integer greater or equal than 2, comprising the following steps:

   - computing in a Galois field redundancy values, said redundancy values including a first value (C1) and a second value (C2),
   - assigning to each of said redundancy values and of said m-l values (Vn) a different rank (n), said rank (n) being an integer belonging to the range 1 to m, the rank of said first value (C1) being 1 and the rank of said second value (C2) being 2,
   - multiplying in said Galois field each of said redundancy values and of said m-l values (Vn) by its corresponding rank (n), and obtaining corresponding weighted values (Pn),
   wherein
   said redundancy values (C1, C2) are computed so that

   - the sum in said Galois field of said redundancy values (C1, C2) and of said m-l values (Vn) is predetermined, for example zero
   - the sum in said Galois field of the weighted values (1 *C1, 2*C2, Pn) is predetermined, for example zero.

2. The method of claim 1, wherein l equals 2, and wherein said redundancy values comprises said first value (C1) and said second value (C2) only, and wherein m weighted values are computed.

3. The method of one of the claims 1 or 2, wherein said Galois field is the GF(256) Galois field.

4. The method of claim 3, said multiplying in said Galois field being based on the irreducible polynomial $p(x) = x^8 + x^6 + x^3 + x^2 + 1$ (333).

5. The method of one of claims 3 or 4, said multiplying in said Galois field being performed as follows:

$$\text{mul}(c, d) = (8\{c_7\} \text{ and } \text{m128}(d))$$

$$\text{xor}(8\{c_6\} \text{ and } \text{m64}(d))$$

$$\text{xor}(8\{c_5\} \text{ and } \text{m32}(d))$$

$$xor\ (\ 8\{c_4\}\ and\ \ m16(d))$$

$$xor\ (\ 8\{c_3\}\ and\ \ \ m8(d))$$

$$xor\ (\ 8\{c_2\}\ and\ \ \ m4(d))$$

$$xor\ (\ 8\{c_1\}\ and\ \ \ m2(d))$$

$$xor\ (\ 8\{c_0\}\ and\ \ \ m1(d))$$

6. The method of one of the claims 1 to 5, said computing in said Galois field of said second value (C2) comprising:

- summing in said Galois field said m-l values (Vn), and obtaining a first partial sum ($\Sigma V_{part}$),
- summing in said Galois field corresponding m-l weighted values (Pn), and obtaining a second partial sum ($\Sigma P_{part}$).
- computing an inverse operation (inv_op) on the results of a XOR operation between said first partial sum ($\Sigma V_{part}$) and said second partial sum ($\Sigma P_{part}$).

7. The method of the claim 6, said inverse operation (inv_op) allowing to calculate a value r from the knowledge of a value d, said value r and said value d being related by the following formula:

$$d = m2(r)\ XOR\ r$$

wherein m2 (r) indicates 2*r.

8. The method of the claim 7, when depending on claim 2, said inverse operation calculate said value r as follows:

$$r_7 = d_7\ xor\ d_6\ xor\ d_5\ xor\ d_4\ xor\ d_3\ xor\ d_2\ xor\ d_1\ xor\ d_0$$

$$r_6 = d_6\ xor\ d_5\ xor\ d_4\ xor\ d_3\ xor\ d_2\ xor\ d_1\ xor\ d_0$$

$$r_5 = d_7\ xor\ d_6$$

$$r_4 = d_7\ xor\ d_6\ xor\ d_5$$

$$r_3 = d_7\ xor\ d_6\ xor\ d_5\ xor\ d_4$$

$$r_2 = d_2\ xor\ d_1\ xor\ d_0$$

$$r_1 = d_7\ xor\ d_6\ xor\ d_5\ xor\ d_4\ xor\ d_3\ xor\ d_2$$

$$r_0 = d_7\ xor\ d_6\ xor\ d_5\ xor\ d_4\ xor\ d_3\ xor\ d_2\ xor\ d_1$$

9. The method of one of the claims 6 to 8, said computing in said Galois field of said first value (C1) comprising:

- performing a XOR operation between said first partial sum ($\sum V_{part}$) and said second value (C2).

10. A device for encoding m-l values (Vn), wherein m is an integer greater or equal than 3 and wherein l is an integer greater or equal than 2, comprising:

- computing modules (2, 3, 4, 5, 6, 7, 8, 9) arranged for computing in a Galois field redundancy values including a first value (C1) and a second value (C2), so that
- the sum in said Galois field of said redundancy values (C1, C2) and said m-l values (Vn) is predetermined, for example zero
- the sum in said Galois field of weighted redundancy values (1\*C1, 2\*C2) and weighted m-l values (Pn) is predetermined, for example zero
each weighted value being the result of multiplying in said Galois field each value by a different rank (n), said rank (n) being an integer belonging to the range from 1 to m, the rank of said first value (C1) being 1 and the rank of said second value (C2) being 2,

- a multiplexer (10) for selecting said redundancy values (C1, C2) and said m-l values (Vn) so as to create a block.

11. The device of claim 10, said computing modules (2, 4, 3, 5, 6, 9, 7) comprising:

- a first XOR module (4) and a first register (2) arranged for summing in said Galois field said m-2 values (Vn), and obtaining a first partial sum ($\sum V_{part}$),
- a counter (1) and a multiplier (8) arranged for multiplying each m-l values (Vn) by said rank (n), and obtaining a corresponding weighted value (Pn),
- a second XOR module (5) and a second register (3) arranged for summing in said Galois field said m-l weighted values (Pn), and obtaining a second partial sum ($\sum P_{part}$),
- a third XOR module (6) arranged for summing said first partial sum ($\sum S_{part}$) and said second partial sum ($\sum P_{part}$),
- an inverse operation module (9) arranged for applying an inverse operation (inv_op) on the output of the third XOR module (6), so as to compute the second value (C2),
- a fourth XOR module (7) arranged for summing said first partial sum ($EV_{part}$) with second value (C2), so as to compute the first value (C1).

12. A method for decoding m values (Vn), wherein m is a integer equal or greater than 3, wherein l is an integer greater or equal than two, comprising the following steps:

- receiving a block of m values (Vn), comprising redundancy values and m-l values (Vn), said redundancy values including a first value (C1) a second value (C2),
- multiplying in a Galois field each value of said block by a different rank (n), said rank (n) being an integer belonging to the range from 1 to m, the rank of said first value (C1) being 1 and the rank of said second value (C2) being 2,
- summing in said Galois field said m values (Vn), and obtaining a first total sum ($\sum V$),
- summing in said Galois field said m weighted values (Pn), and obtaining a second total sum ($\sum P$),
- verifying if at least one of said first total sum ($\sum V$) or said second total sum ($\sum P$) is different from a predetermined value, for example zero,
- if at least one of said first total sum ($\sum V$) or said second total sum ($\sum P$) is different from said predetermined value, determining the position of an erroneous value and correcting said erroneous value.

13. The method of claim 12, wherein said determining the position of said erroneous value comprises:

- dividing in said Galois field said second total sum ($\sum P$) by said first total sum ($\sum V$).

14. The method of claim 12, wherein said determining the position of said error comprises:

- verifying by using the brute force method which value of n satisfies the following formula:

$$\Sigma P = \text{mul}(n, \Sigma V)$$

**15.** The method of one of claims 12 to 14, wherein correcting said erroneous value comprising:

- applying a XOR operation between said erroneous value and said first total sum ($\Sigma V$).

**16.** The method of one of claims 12 to 15, wherein the outputting of corrected values from a decoder is carried out in parallel with their input into said decoder.

**17.** A device for decoding m values (Vn), wherein m is an integer equal or greater than 3, comprising:

- an input module (IN) for receiving a block of values comprising m-l values (Vn) as well as redundancy values including a first value (C1) and a second value (C2), l being an integer greater or equal than 2;
- a first counter (100) arranged for indicating the current rank of each of the m values (Vn), counting backwards from m to 1, said rank (n) being an integer belonging to the range from 1 to m, the rank of said first value (C1) being 1 and the rank of said second value (C2) being 2,
- a multiplier (110) arranged for multiplying in a Galois field each value of said block by its corresponding rank (n),
- a first XOR module (800) and a first register (400) arranged for summing in said Galois field said m values (Vn), and obtaining a first total sum ($\Sigma V$),
- a second XOR module (900) and a third register (600) arranged for summing in said Galois field said m weighted values (Pn), and obtaining a second total sum ($\Sigma P$),
- a first comparator (120) arranged for verifying if at least one of said first total sum ($\Sigma V$) or said second total sum ($\Sigma P$) is different from said predetermined value,
- a computing module arranged for determining the position (n) of an erroneous value in said block.

**18.** The device of the claim 17, said computing module comprising a divider (130) arranged for dividing said second total sum ($\Sigma P$) by said first total sum ($\Sigma V$) so as to determine the position (n) of an erroneous value in said ordered block, if at least one of said first total sum ($\Sigma V$) or said second total sum ($\Sigma P$) is different from said predetermined value.

**19.** The device of the claim 17, said computing module comprising a multiplier (132) arranged for multiplies the first total sum ($\Sigma V$) by the current rank n from a second counter (202) by applying the force brute method, so as to determine the position (n) of an erroneous value in said ordered block, if at least one of said first total sum ($\Sigma V$) or said second total sum ($\Sigma P$) is different from said predetermined.

**20.** The device of one of the claims 17 to 19, further comprising:

- a third XOR module (1000) arranged for correcting said erroneous value from the value having the rank (n) of the erroneous value, and the first total sum ($\Sigma V$).

**21.** A computer-program product for causing an apparatus to encoding m-l values respectively to decoding m values, comprising a tangible computer usable medium including computer usable program code being used for performing the steps of any one of the methods of claims 1 to 9 or 12 to 16.

**22.** A computer data carrier storing data encoded with the method of any one of claims 1 to 9.

Fig. 1

Fig. 2

Fig. 3

## EUROPEAN SEARCH REPORT

Application Number

EP 13 17 7847

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | WO 2012/099937 A2 (LSI CORP [US]; WERNER JEREMY ISAAC NATHANIEL [US]; BARYUDIN LEONID [US) 26 July 2012 (2012-07-26) | 10,11, 16-22 | INV. H03M13/09 G06F11/08 |
| A | * abstract * <br> * paragraph [0029] - paragraph [0034]; figures 12, 13 * <br> * paragraph [0273] - paragraph [0324] * | 1-9, 12-15 | |
| A | EP 2 608 414 A2 (TROPF HERMANN [DE]) 26 June 2013 (2013-06-26) <br> * paragraph [0018] - paragraph [0027] * | 1-22 | |
| A | Kazuya Saito ET AL: "A Formal Approach to Designing Arithmetic Circuits over Galois Fields Using Symbolic Computer Algebra", SASIMI 2012 Proceedings, 8 March 2012 (2012-03-08), pages 153-158, XP055082332, Retrieved from the Internet: URL:http://sasimi.jp/new/sasimi2012/files/program/archive/pdf/p153_R2-2.pdf [retrieved on 2013-10-02] <br> * the whole document * | 1-21 | |
| A | Anonym: "Galois Field Arithmetic Implementation", , 17 May 2006 (2006-05-17), pages 1-8, XP055082337, Retrieved from the Internet: URL:https://ccnet.stanford.edu/cgi-bin/course.cgi?cc=spr06/ee387&action=handout_download&handout_id=ID114806226126591 [retrieved on 2013-10-02] <br> * the whole document * | 1-21 | |

TECHNICAL FIELDS SEARCHED (IPC)

H03M
G06F

-/--

The present search report has been drawn up for all claims

| Place of search | Date of completion of the search | Examiner |
|---|---|---|
| The Hague | 3 October 2013 | Belardinelli, Carlo |

EPO FORM 1503 03.82 (P04C01)

## EUROPEAN SEARCH REPORT

Application Number

EP 13 17 7847

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | Anonym: "Galois Field Arithmetic", pclviewer.com , 30 August 2012 (2012-08-30), XP002714110, Retrieved from the Internet: URL:http://web.archive.org/web/20120830174500/http://www.pclviewer.com/rs2/galois.html [retrieved on 2013-10-02] * the whole document * * table 1 * ----- | 1-21 | |

TECHNICAL FIELDS
SEARCHED      (IPC)

The present search report has been drawn up for all claims

| Place of search | Date of completion of the search | Examiner |
|---|---|---|
| The Hague | 3 October 2013 | Belardinelli, Carlo |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

......................................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 13 17 7847

This annex lists the patent family members relating to the patent documents cited in the above-mentioned European search report.
The members are as contained in the European Patent Office EDP file on
The European Patent Office is in no way liable for these particulars which are merely given for the purpose of information.

03-10-2013

| Patent document cited in search report | | Publication date | Patent family member(s) | | Publication date |
|---|---|---|---|---|---|
| WO 2012099937 | A2 | 26-07-2012 | TW 201241615 | A | 16-10-2012 |
| | | | WO 2012099937 | A2 | 26-07-2012 |
| EP 2608414 | A2 | 26-06-2013 | DE 102011110121 | B3 | 25-10-2012 |
| | | | EP 2608414 | A2 | 26-06-2013 |

EPO FORM P0459

For more details about this annex : see Official Journal of the European Patent Office, No. 12/82